# EUROPÄISCHE PATENTSCHRIFT

(11) **EP 1 476 904 B1**
(45) Veröffentlichungstag und Bekanntmachung des Hinweises auf die Patenterteilung: **24.06.2009**
(21) Anmeldenummer: 03720124.1
(22) Anmeldetag: 21.02.2003
(51) Int. Cl.: H01L 27/08, H01L 29/94

(54) **INTEGRIERTE HALBLEITERSCHALTUNG MIT EINER PARALLELSCHALTUNG GEKOPPELTER KAPAZIT TEN**
INTEGRATED SEMICONDUCTOR CIRCUIT COMPRISING A PARALLEL CONNECTION OF COUPLED CAPACITORS
CIRCUIT A SEMI-CONDUCTEURS INTEGRE COMPORTANT UN CIRCUIT PARALLELE DE CONDENSATEURS COUPLES

(30) Priorität: 22.02.2002 DE 10207739
(43) Veröffentlichungstag der Anmeldung: 17.11.2004
(73) Patentinhaber: Infineon Technologies AG, 85579 Neubiberg (DE)
(72) Erfinder: BRENNER, Pietro, 85560 Ebersberg (DE)
(74) Vertreter: Viering, Jentschura & Partner
(86) Internationale Anmeldenummer: PCT/DE2003/000547
(87) Internationale Veröffentlichungsnummer: WO 2003/073510

(56) Entgegenhaltungen:
- US-A- 5 576 565
- US-A- 5 747 865
- US-A- 5 801 411
- US-B1- 6 222 221
- PATENT ABSTRACTS OF JAPAN vol. 2000, no. 23, 10. Februar 2001 (2001-02-10) -& JP 2001 177059 A (MOTOROLA INC), 29. Juni 2001 (2001-06-29) -& US 6 351 020 B1 (CHAN JOSEPH Y ET AL) 26. Februar 2002 (2002-02-26)
- PATENT ABSTRACTS OF JAPAN vol. 014, no. 374 (E-0964), 13. August 1990 (1990-08-13) -& JP 02 137256 A (NEC CORP), 25. Mai 1990 (1990-05-25)

## Beschreibung

Die Erfindung betrifft eine integrierte Halbleiterschaltung nach dem Oberbegriff des Anspruchs 1. Erfindung betrifft ferner eine integrierte Halbleiterschaltung nach dem Oberbegriff des Anspruchs 2. Derartige Halbleiterschaltungen weisen jeweils zwei Kondensatoren mit jeweils einer erster Elektrode, einer zweiter Elektrode, die eine dotierte Schicht aufweist, und ein Dielektrikum auf.

US6351020 und US5801411 offenbaren Kondensatorschaltungen.

Integrierte Halbleiterschaltungen erfordern neben aktiven Bauelementen wie Transistoren auch passive Bauelemente wie Kondensatoren; letztere können auch in Transistorbauweise, beispielsweise nach der MOS-Technologie (metal oxide semiconductor) hergestellt werden, wobei die gleichen Herstellungsschritte wie bei Herstellung eines MOSFET-Transistors (field effect Transistor) verwendet werden, um die Kondensatoren herzustellen. Source- und Drain-Elektroden werden in eine dotierte Substratwanne gleichen Dotierungstyps wie die Source-/Drain-Implantationen eingebracht. Source und Drain werden bei der Fertigung der Metallisierung miteinander elektrisch kurzgeschlossen. Auf diese Weise wird eine unterhalb eines Gate-Schichtenstapels angeordnete Kondensatorelektrode hergestellt; die andere Kondensatorelektrode wird durch die Gateelektrode selbst gebildet. Die Gate-Isolations-Schicht, meist aus Siliziumdioxid, bildet das Dielektrikum dieses Kondensators, an den zwischen der Gateelektrode und den miteinander kurzgeschlossenen Source-/Drain-Elektroden die Kondensatorspannung angelegt wird.

Andere Technologien verwenden andere Dielektrika (Nitride, Oxid-Nitrid-Oxid-Schichtenfolgen, Aluminiumoxid, Tantaloxid oder andere) auf der Oberfläche eines Siliziumsubstrates als Kondensatordielektrikum; auch in diesem Fall dient vorzugsweise eine hochdotierte Substratwanne als untere Elektrode, hier allerdings ohne Source/Drain-Implantationen. Die zweite Elektrode wird auf der dielektrischen Schicht, etwa einer Nitridschicht abgeschieden. Aufgrund der elektrischen isolierenden Eigenschaft der Nitridschicht wird diese Technologie als MIS (metal insulator semiconductor)-Technologie bezeichnet.

Bei den geschilderten Technologien enthält die obere Kondensatorelektrode meist eine Schicht aus dotierten Material, vorzugsweise Polysilizium, die meist unmittelbar auf dem isolierenden Gatedielektrikum aufgebracht ist. Die andere Elektrode wird durch einen dotierten Bereich des Halbleitersubstrat gebildet. Neuere Technologien sehen darüber hinaus vor, auf beiden Seiten des Dielektrikums polykristalline Halbleiterelektroden anzuordnen.

Wenn eine Kondensatorelektrode eine dotierte Schicht enthält, tritt der sogenannte Poly-Depletion-Effekt auf, der sich dadurch äußert, daß die Kapazitäts-Spannungs-Charakteristik verändert wird. Die Kapazität eines in MOS- oder MIS-Technologie hergestellten Kondensators hängt von der angelegten Spannung ab; bei MOS-Kondensatoren ist die Kapazität bei negativen Vorspannungen der Gateelektrode zum Substrat aufgrund einer Ladungsträgerverarmung sehr gering, während bei positiver Vorspannung eine sehr viel höhere Kapazität erreicht wird (Akkumulation). Insbesondere bei Vorspannungen von mehr als 1 Volt über der Flachbandspannung ist die Kapazität in etwa linear, der Poly-Depletion-Effekt führt jedoch zu einem nichtlinearen Kapazitätsanteil, der um so ausgeprägter ist je dünner die dielektrische Isolationsschicht ist.

Der Poly-Depletion-Effekt und die starke Spannungsabhängigkeit der Kapazität im Verarmungs- und Flachbandbereich eines in MOS- oder MIS- Technologie hergestellten Kondensators führen dazu, daß diese Kondensatoren in linearen Schaltungen nur sehr eingeschränkt verwendbar ist und oft aufwendige Zusatzschaltungen benötigen, um eine Linearisierung oder eine Veränderung der Spannungsabhängigkeit ihrer Kapazitätskennlinie zu erreichen.

Um einen Kondensator bereitzustellen, dessen Kapazitätsverlauf über einen größeren Spannungsbereich von Einflüssen der dotierten Elektrodenschicht unabhängig ist und dessen Kapazität auch bei besonders kleinen positiven Vorspannungen ohne aufwendige Zusatzschaltungen verwendbar ist, sind bei den Halbleiterschaltungen gemäß dem Oberbegriff des Anspruchs 1 und des Anspruchs 2 Parallelschaltungen zweier Einzelkondensatoren vorgesehen, wobei die jeweilige Parallelschaltung einen Gesamtkondensator mit einem in etwa linearen Verlauf der Gesamtkapazität in Abhängigkeit von der anliegenden Spannung darstellt.

Gemäß dem Oberbegriff des Anspruchs 1 ist eine Parallelschaltung zweier Kondensatoren vorgesehen, bei der je eine Elektrode des ersten Kondensators und des zweiten Kondensators durch einen ersten gemeinsamen Elektrodenanschluß miteinander kurzgeschlossen sind und bei der die jeweils anderen Elektroden des ersten und des zweiten Kondensators durch einen zweiten gemeinsamen Elektrodenanschluß miteinander kurzgeschlossen sind, wobei die dotierten Schichten beider Kondensatoren mit Dotierstoffen desselben Dotierungstyps dotiert sind und der erste Kondensator und der zweite Kondensator gegensinnig parallelgeschaltet sind, so daß die dotierte Schicht des einen Kondensators an den einen gemeinsamen Elektrodenanschluß und die dotierte Schicht des anderen Kondensators an den anderen gemeinsamen Elektrodenanschluß angeschlossen ist. Hierbei werden zwei Kondensatoren, deren dotierte Schichten (und auch Substratelektroden) mit dem gleichen Dotierungstyp dotiert sind, antiparallel zueinander geschaltet, wodurch eine spiegelbildliche Überlagerung zweier Kapazitäts-Spannungs-Kennlinien entsteht. Durch unterschiedlich große Kapazitätsflächen kann man die zu addierenden Kapazitäts-Spannungs-Kennlinien unterschiedlich gewichten. Der sich ergebende Kapazitätsverlauf ist auch bei kleineren Vorspannungen ab etwa 0,5 Volt praktisch linear.

Gemäß dem Oberbegriff des Anspruchs 2 ist eine Parallelschaltung zweier Kondensatoren vorgesehen, bei der je eine Elektrode des ersten Kondensators und des zweiten Kondensators durch einen ersten gemeinsamen Elektrodenanschluß miteinander kurzgeschlossen sind und bei der die jeweils anderen Elektroden des ersten und des zweiten Kondensators durch einen zweiten gemeinsamen Elektrodenanschluß miteinander kurzgeschlossen sind, wobei die dotierte Schicht des einen Kondensators negativ dotiert und die dotierte Schicht des anderen Kondensators positiv dotiert ist und die beiden Kondensatoren gleichsinnig parallelgeschaltet sind, so daß beide dotierten Schichten durch einen gemeinsamen Elektrodenanschluß miteinander kurzgeschlossen sind. Hierbei werden beispielsweise zwei n-Wannen-Kondensatoren gleichsinnig parallelgeschaltet, indem beide Gateelektroden an denselben Pol der an die Parallelschaltung angelegten Kondensatorspannung angeschlossen werden. Die Wannenkontakte werden beide mit dem anderen Pol der Vorspannung verbunden. Die erste Elektrode (Substratwanne mit Source/Drain-Implantationen) und die zweite Elektrode (bzw. ihre dotierte Schichtschicht) sind beim ersten Kondensator positiv, beim zweiten negativ dotiert. Auf diese Weise ergibt sich eine Gesamtkapazitäts-Charakteristik, die im zulässigen Spannungsbereich auch bei niedrigen Absolutspannungen bis 0,0 Volt linear verläuft.

Bei beiden gattungsbildenden Arten von Halbleiterschaltungen sind zwei Kondensatoren parallelgeschaltet und ergeben dadurch eine Kapazität, die eine veränderte Kapazitätskennlinie aufweist. Der Verlauf der Kennlinie wird dadurch eingestellt, daß die Polungsrichtungen der Kondensatoren und die Vorzeichen der Dotierungen der dotierten Schichten (d.h. die Art des Ladungsträgertyps, also n-dotiert oder p-dotiert) in geeigneter Weise gewählt werden. Durch die Wahl der Polungsrichtung eines Kondensators kann seine Kapazitätskennlinie spiegelbildlich für Vorspannungen mit geändertem Vorzeichen verwendet werden. Die je nach Polungsrichtungen der Kondensatoren gleichsinnige oder gegensinnige Parallelschaltung dieser Kondensatoren besitzt eine Gesamtkapazität, die der Summe zweier Kapazitätskennlinien entspricht. Die Kapazitätskennlinie jedes einzelnen Kondensators ist unsymmetrisch bezüglich positiver und negativer Vorspannungen; beispielsweise ist die Kapazität im Falle positiver Vorspannungen wesentlich größer als im Falle negativer Vorspannungen. Der einzelne Kondensator besitzt daher beispielsweise bei positiver Vorspannung eine hohe Kapazität, die im Falle eines MOS-Kondensators auf einer Anreicherung von Ladungsträgern beruht. Im Bereich negativer Vorspannungen ist seine Kapazität aufgrund der Ausbildung einer Verarmungszone unter dem Isolator wesentlich geringer und nimmt mit zunehmenden Absolutwert der Spannung weiter ab.

Bei beiden gattungsbildenden Arten von Halbleiterschaltungen werden zwei Kondensatoren auf eine Weise parallelgeschaltet, daß der eine Kondensator im Bereich sehr hoher Kapazitätswerte betrieben wird, wohingegen der andere Kondensator im Bereich wesentlich kleiner Kapazitätswerte betrieben wird. Durch die passende Wahl der Orientierung beziehungsweise Polungsrichtung zweier parallelgeschalteter Kondensatoren und der passenden Wahl des Dotierungstyps der dotierten Schichten ihrer zweiten Elektroden werden für eine vorgegebene Einzelkapazitätskennlinie der Kennlinienverlauf für positive Spannungen und der Kennlinienverlauf für negative Vorspannungen summiert; die sich durch diese Addition ergebende Gesamtkennlinie verläuft in größeren Spannungsbereichen und dort in höherem Maße linear als die Kennlinie des einzelnen Kondensators. Insbesondere erstreckt sich der Bereich des linearen Kapazitätsverlaufes auch bis zu kleinen Spannungswerten hinab bis zu 0,0 Volt.

Die dotierte Schicht des einen Kondensators wird mit einem Potential verbunden, dessen Vorzeichen mit dem Vorzeichen der Dotierung dieser dotierte Schicht übereinstimmt, wohingegen die dotierte Schicht des anderen Kondensators mit einen Potential verbunden wird, dessen Vorzeichen zum Vorzeichen der Dotierung dieser letzteren dotierten Schicht entgegengesetzt ist. Im Falle von MOS-Kondensatoren entsteht in der einen dotierten Schicht eine Anreicherung, in der anderen eine Verarmung von Ladungsträgern. Das Anschließen der dotierten Schichten beider Kondensatoren mit Vorspannungspotentialen des jeweils passenden Vorzeichens wird durch entsprechende Polungsrichtungen der zwei Kondensatoren und durch die Wahl einer n-Dotierung oder p-Dotierung der dotierten Schichten erreicht.

Durch die Parallelschaltung zweier Kondensatoren wird eine weitgehend lineare Gesamtkapazität erzielt, die für die meisten Zwecke ausreichend ist. Dennoch bestehen geringe Abweichungen von einer exakt linearen Kapazitäts-Spannungs-Charakteristik, die insbesondere in analogen Schaltungen den Einsatz von Kapazitäten aus parallel geschalteten Kondensatoren einschränken können. Eine weitergehende Linearisierung ließe sich zwar durch das Verschalten noch weiterer Kondensatoren, beispielsweise von insgesamt vier parallel verschalteten Einzelkondensatoren erreichen; hierdurch wird jedoch diejenige Chipfläche wieder teilweise verbraucht, die aufgrund des Fortfalls linearisierender Korrekturschaltungen eingespart wurde.

Es ist die Aufgabe der vorliegenden Erfindung, eine integrierte Halbleiterschaltung mit einem Kondensator bereitzustellen, dessen Kapazitätsverlauf eine noch geringere Abweichung von einer idealen, linearen Kapazitäts-Spannungs-Charakteristik besitzt. Insbesondere soll eine möglichst gute Übereinstimmung mit dem linearen Kennlinienverlauf bei möglichst geringer Substratgrundfläche für die lineare Kapazität erzielt werden.

Diese Aufgabe wird bei den gattungsgemäßen integrierten Halbleiterschaltungen gemäß den Ansprüchen 1 und 2 dadurch gelöst, daß die Grundflächen der dotierten Schichten des ersten Kondensators und des zweiten Kondensators unterschiedlich groß sind. Erfindungsgemäß werden für die beiden zueinander parallel geschalteten Einzelkondensatoren unterschiedliche Grundflächen der dotierten Schichten der zweiten Elektroden vorgesehen. Während üblicherweise auf einem Halbleiterchip alle Strukturen so klein wie möglich, d.h. mit der jeweiligen optischen Auflösungsgrenze strukturiert werden und insbesondere MOS-Strukturen eine möglichst kleine Substratgrundfläche einnehmen sollen, wird erfindungsgemäß die Veränderung, insbesondere Vergrößerung der Grundfläche einer MOS-Struktur benutzt, um eine unterschiedliche Gewichtung zweier MOS-Kondensatoren in der zur Gesamtkapazität führenden Parallelschaltung vorzunehmen. Herkömmlich sind die Abmessungen eines MOS-Transistors vorgegeben und werden, soweit sie verändert werden, für eine konkrete Halbleiterschaltung stets einheitlich gewählt. Zumindest innerhalb eines eng umrissenen Teilschaltkreises einer Halbleiterschaltung werden üblicherweise einheitliche Transistorabmessungen gewählt. Dies gilt auch dann, wenn solche MOS-Strukturen als Kondensatoren mit miteinander kurzgeschlossenen Source- und Drain-Gebieten eingesetzt werden.

Während herkömmlich zur Linearisierung der Kapazitäts-Spannungs-Kapazität zusätzliche Korrekturschaltungen vorgesehen wurden, wird erfindungsgemäß die Grundfläche der dotierten Schicht der einen der beiden parallel geschalteten Kondensatoren im Vergleich zur Grundfläche der dotierten Schicht des anderen Kondensators vergrößert oder verkleinert, wodurch ein zusätzlicher Freiheitsgrad für die Optimierung des Kennlinienverlaufs gewonnen ist. Die Linearisierung kann insbesondere in der Weise erfolgen, daß etwa im Falle einer MOS-Struktur oder einer MIS-Struktur für beide Kondensatoren eine einheitliche Breite der Gate-Elektrode, d.h. der Wortleitungen oder der entsprechenden Leiterbahnen im Logikbereich gewählt wird, wohingegen die Ausdehnung der ersten Elektroden beider Kondensatoren in Längsrichtung der jeweiligen Leiterbahn unterschiedlich groß gewählt werden. Hierbei können alle Leiterbahnen, die bereichsweise die zweiten Elektroden und die dotierten Schichten der Kondensatoren ausbilden, mit gleicher, identischer Leiterbahnbreite gefertigt werden, was im Falle von MOS-Strukturen einer einheitlichen Kanallänge entspricht. Die erfindungsgemäße Ausbildung unterschiedlich großer Grundflächen der dotierten Schichten im Bereich der miteinander parallel geschalteten Kondensatoren wird eine weitergehende Linearisierung erreichbar als im Falle einheitlicher Kondensatorflächen. Da unter Umständen schon geringe Vergrößerungen der Grundflächen z.B. längs von Leiterbahnen der zweiten Elektroden ausreicht, um eine passende Gewichtung beider Einzelkapazitäten zu erreichen, wird sehr wenig zusätzliche Chipfläche verbraucht.

Vorzugsweise ist vorgesehen, daß die Grundflächen beider dotierten Schichten ein Flächenverhältnis von zwischen 0,2 und 5,0 besitzen. Werden unterschiedlich starke Dotierungen für den ersten und den zweiten Kondensator in der jeweiligen dotierten Schicht verwendet oder werden andere Parameter oder Kombinationen von Parametern unterschiedlich groß gewählt, können die Grundflächenverhältnisse auch zwischen 1:10 und 10:1 oder in einem größeren Bereich variieren.

Für den Fall, daß zwei Kondensatoren gleichsinnig parallel miteinander verschaltet sind, deren dotierte Schichten mit Dotierstoffen unterschiedlichen Leitungstyps dotiert sind, ist vorzugsweise vorgesehen, daß die Grundfläche der positiv dotierten Schicht kleiner ist als die Grundfläche der negativ dotierten Schicht. Beispielsweise kann die Grundfläche der positiv dotierten Schicht zwischen 65 % und 85 % der Grundfläche der negativ dotierten Schicht betragen.

Weitere Ausführungsformen sehen vor, daß die dotierten Schichten der zweiten Elektroden der beiden Kondensatoren mit Dotierstoffen in Konzentrationen zwischen 10¹⁷/cm³ und 10²¹/cm³ dotiert sind, und daß die dotierten Schichten der zweiten Elektroden der beiden Kondensatoren mit Bor, Phosphor oder Arsen dotiert sind.

Vorzugsweise ist vorgesehen, daß dotierten Schichten der Elektroden polykristalline Schichten, insbesondere Polysiliziumschichten sind. Es können aber auch polykristalline Schichten aus anderen Materialien vorgesehen sein. Die dotierten Schichten gehören zu den oberen Elektroden, die sich über dem Dielektrikum auf dem Substrat befinden.

Vorzugsweise ist vorgesehen, daß die ersten Elektroden des ersten und zweiten Kondensators dotierte Gebiete eines Halbleitersubstrats sind. Die zweiten Elektroden, die jeweils eine dotierte Schicht enthalten, sind dann durch eine isolierende Schicht von dem Halbleitersubstrat getrennt.

Insbesondere enthält diese isolierende, dielektrische Schicht des ersten und des zweiten Kondensators jeweils ein Nitrid. Das Nitrid kann etwa als mittlere Schicht einer Oxid-Nitrid-Oxid-Schichtenfolge enthalten sein. ONO-Schichtenfolgen werden bei der Herstellung von MISCAPs, d.h. metal-insulator-semiconductor-Kapazitäten als Dielektrikum eingesetzt.

Eine Ausführungsform, die auf MOS-Kapazitäten in Transistorbauweise gerichtet ist, sieht vor, daß die dielektrischen Schichten des ersten und des zweiten Kondensators auf dem Halbleitersubstrat angeordnete Oxidschichten sind und daß beim ersten Kondensator und beim zweiten Kondensator die erste Elektrode jeweils eine unterhalb der Oxidschicht des Kondensators angeordnete dotierte Substratwanne aufweist, in die auf zwei gegenüberliegenden Seiten der Grundfläche der zweiten Elektrode zwei Implantationsgebiete eingebracht sind, die eine Dotierung gleichen Dotierungstyps wie die Substratwanne, aber höherer Dotierungskonzentration aufweisen und die mit der Substratwanne und miteinander elektrisch kurzgeschlossen sind.

Hierbei werden Source/Drain-Implantationen, welche - anders als bei MOSFET-Transistoren mit gleichem Dotierungstyp wie die Substratwanne direkt unterhalb des Gateoxids dotiert sind - gemeinsam mit der Substratwanne als erste Elektrode verwendet. Der Gate-Schichtenstapel mit der dotierten Schicht dient als zweite Elektrode, die von der ersten durch die dielektrische Gate-Isolation getrennt ist. Source- und Drain-Implantationen sind über Leiterbahnen miteinander kurzgeschlossen und im Substrat mit der mit gleichem Dotierungstyp dotierten Wanne im Substrat leitend verbunden.

Die bei diesen Ausführungsformen erzielte spiegelbildliche Addition zweier unterschiedlich gewichteter Kapazitätskennlinien führt zu einer Gesamtkapazität der Parallelschaltung mit einem sehr linearen Kapazitätsverlauf, der keine aufwendigen Korrekturschaltungen für die Kompensation von Nichtlinearitätseffekten mehr erfordert.

Zur weiteren Optimierung der Gesamtkapazität ist vorgesehen, daß die Grundflächen der dotierten Schichten des ersten Kondensators und des zweiten Kondensators unterschiedlich groß sind. Durch unterschiedlich große Grundflächen der dotierten Schichten der zweiten Elektroden, d. h. der beiden Kondensatoren läßt sich eine unterschiedliche Gewichtung der einen Kennlinie relativ zur anderen erreichen. Vor allem bei einem gewünschten linearen Kapazitätsverlauf eignet sich eine Korrektur der Grundflächen, um quadratische Spannungsabhängigkeiten der Kapazitätskennlinie weitgehend zu beseitigen.

Vorzugsweise besitzen die Grundflächen beider polykristalliner Halbleiterschichten ein Flächenverhältnis von zwischen 0,2 und 5,0.

Insbesondere ist vorgesehen, daß das Verhältnis der Grundflächen der dotierte Schichten des ersten und des zweiten Kondensators so gewählt ist, daß die Parallelschaltung eine Gesamtkapazität besitzt, die über einen Bereich variabler Vorspannungen linear verläuft.

Jedoch können beide dotierte Schichten auch ähnlich große, insbesondere gleich große Grundflächen besitzen, vorzugsweise bei Verwendung von Metall-Isolator-Halbleiter-Kondensatoren (MISCAP), mit denen bei einer Spannung um 0,0 Volt eine weitgehend stationäre, d. h. gleichbleibende Gesamtkapazität erzielt werden soll. Durch die gleichsinnige Parallelschaltung zweier MISCAP-Kapazitäten unterschiedlichen Dotierungstyps wird entsprechend der spiegelbildlichen Kennlinienaddition eine bis auf quadratische Korrekturen stationäre Gesamtkapazität erreicht.

Eine andere Ausführungsform sieht vor, daß die zweiten Elektroden des ersten und des zweiten Kondensators Substratelektroden sind und daß die dotierten Schichten der zweiten Elektroden im Halbleitersubstrat angeordnet sind. Diese Ausführungsform ist auf Zukunftstechnologien gerichtet, die Kondensatoren vorsehen, die anstelle einer polykristallinen Schicht eine metallische obere Elektrode aus beispielsweise Tantalnitrid, Saliziden oder Aluminium aufweisen. Auch in diesen Fällen kann ein dem Poly-Depletion-Effekt entsprechender Effekt auftreten, allerdings aufgrund von Vorgängen in den im Halbleitersubstrat angeordneten Substratelektroden.

Die Erfindung wird nachstehend anhand der Figuren 1 bis 15 beschrieben. Es zeigen:
- Figur 1: die Kapazitäts-Spannungs-Charakteristik eines ein- zelnen MOS-Kondensators,
- Figur 2: den Kapazitätsverlauf einer ersten erfindungsgemä- ßen Parallelschaltung,
- Figur 3: das Schaltbild dieser Parallelschaltung,
- Figur 4: Kapazitätsverläufe für verschiedene Grundflächen- verhältnisse der dotierte Schichten dieser Paral- lelschaltung und
- Figur 5: einen Querschnitt durch diese Parallelschaltung, realisiert durch eine MOS-Technologie,
- Figur 5A: eine Draufsicht auf die Parallelschaltung aus Fi- gur 5,
- Figur 6: die Kennlinien eines n-Wannen und eines p-Wannen- Kondensators,
- Figur 7: den Kapazitätsverlauf einer zweiten erfindungsge- mäßen Parallelschaltung,
- Figur 8: das Schaltbild dieser Parallelschaltung,
- Figur 9: Kennlinienverläufe für unterschiedliche Grundflä- chenverhältnisse des n-Wannen- und p-Wannen-Kon- densators,
- Figur 10: einen Querschnitt durch diese zweite erfindungsge- mäße Parallelschaltung, ebenfalls realisiert durch eine MOS-Technologie,
- Figur 10A: eine Draufsicht auf die Parallelschaltung aus Fi- gur 10,
- Figur 11: die Kennlinienverläufe je eines in MIS-Technologie hergestellten Kondensators mit n- und p-dotierten dotierten Schichten als obere Elektrode,
- Figur 12: die sich durch Addition beider Kennlinien aus Fi- gur 11 ergebende Gesamtkapazität gemäß einer drit- ten erfindungsgemäßen Parallelschaltung,
- Figur 13: das Schaltbild dieser dritten erfindungsgemäßen Parallelschaltung,
- Figur 14: einen Querschnitt durch diese Parallelschaltung, realisiert in einer MIS-Technologie,
- Figur 14A: eine Draufsicht auf die Parallelschaltung aus Fi- gur 14 und
- Figur 15: eine vereinfachte und kompaktere Bauweise der Schaltung aus Figur 14.

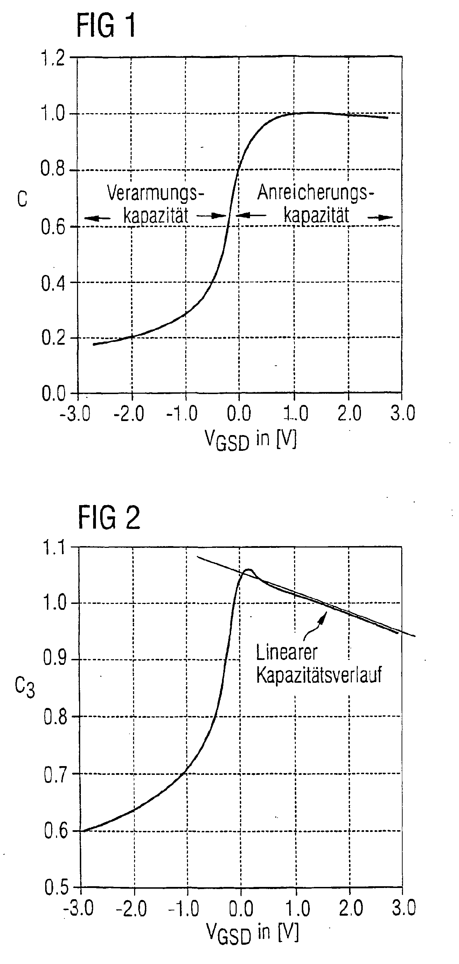

Figur 1 zeigt den typischen Kennlinienverlauf eines MOS-Kondensators, der beispielsweise bei einer positiven Vorspannung V_{GSD} zwischen dem polysiliziumhaltigen Gate zu den miteinander kurzgeschlossenen Source/Drain-Elektroden im Anreicherungsmodus betrieben wird, im Bereich negativer Vorspannungen hingegen im Verarmungsmodus. Im Anreicherungsmodus ist die Kapazität aufgrund eines sehr geringen effektiven Elektrodenabstands sehr hoch und in einem Bereich zwischen 1,25 und 1,75 Volt in etwa linear.

Schaltet man zwei solcher Kondensatoren so parallel, daß die in Figur 1 dargestellte Kennlinie - ggf. mit unterschiedlicher Gewichtung - mit ihrem Spiegelbild bezüglich der V=0-Achse summiert wird, so ergibt sich die in Figur 2 dargestellte Kennlinie. Diese verläuft im Bereich positiver Vorspannungen ab einem Mindestspannungswert von 0,5 Volt praktisch linear und erfordert daher keine aufwendigen Korrekturschaltungen mehr.

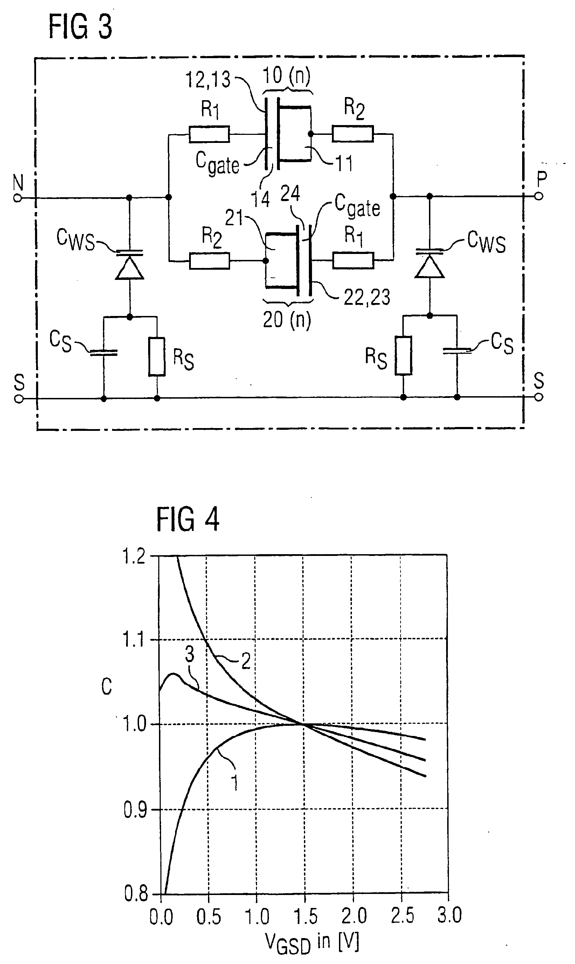

Figur 3 zeigt schematisch das Schaltbild dieser Parallelschaltung, bei der der erste Kondensator 10 und der zweite Kondensator 20 antiparallel miteinander verschaltet sind. Die Polysiliziumschichten 13, 23 der zweiten Elektroden 12, 22 sind mit einer negativen Dotierung (n) versehen, ebenso sind die ersten Elektroden 11, 21 n-dotiert. Das Gate 12 des Kondensators 10 ist mit dem negativen Potential N der Vorspannung V angeschlossen, das Gate 22 des Kondensators 20 hingegen mit dem anderen, positiven Potential P der Vorspannung V. Durch unterschiedliche Grundflächen der jeweiligen Gateoxide 14, 24 lassen sich unterschiedliche Gewichtungen der Kapazitätskennlinien beider Kondensatoren 10, 20 zueinander erreichen und so der Gesamt-Kennlinienverlauf optimieren. Die durch R₁ und R₂ bezeichneten konzentrierten Widerstandselement ergeben sich aufgrund von Leiterbahn-, Kontakt- und Gateelektroden-Serienwiderständen. Die weiteren Anschlußwiderstände Rₛ im Substrat, Anschlußkapazitäten und Anschlußgleichrichter ergeben sich aufgrund der geometrischen Struktur der in MOS-Bauweise gefertigten Parallelschaltung und betreffen nicht den Kern der Erfindung.

Figur 4 zeigt Gesamtkennlinienverläufe für unterschiedliche Grundflächenverhältnisse der dotierten Schichten 13, 23 der Kondensatoren 10 und 20. Die Kennlinie 1 entspricht einem einzelnen Kondensator mit n-dotiertem Polysilizium-Gate bei positiver Vorspannung. Demgegenüber zeigt die Kennlinie 2 eine erfindungsgemäße Parallelschaltung, bei der die Grundflächen beider Kondensatoren 10, 20 gleich groß gewählt sind. Die optimale Anpassung dieser Grundflächen aneinander - bei einer beispielhaft dargestellten Ausführungsform mit doppelt so großer Grundfläche des Kondensators 10 im Vergleich zur Grundfläche des Kondensators 20 - ergibt einen ab 0,5 Volt linearen Verlauf entsprechend der Kennlinie 3.

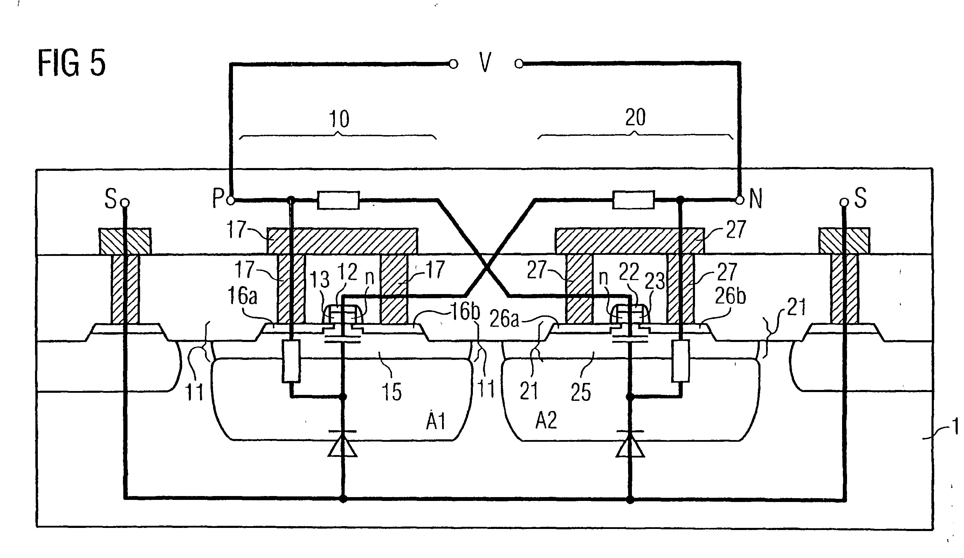

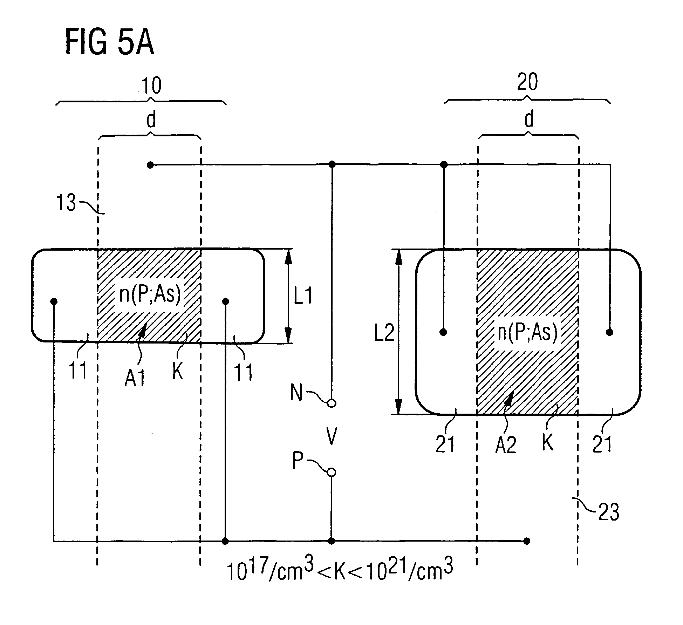

Figur 5 zeigt einen realen Aufbau der erfindungsgemäßen Parallelschaltung aus zwei MOS-Kondensatoren 10 und 20, die mit denselben Verfahrensschritten wie MOS-Feldeffekttransistoren hergestellt werden können. Die Gate-Schichtenstapel 12 und 22 dienen als obere, zweite Elektrode der Kondensatoren 10, 20 und weisen jeweils eine dotierte Schicht 13 bzw. 23 auf. Unter ihnen befindet sich jeweils eine wesentlich breitere dotierte Substratwanne 15, 25, in die jeweils rechts und links des jeweiligen Gate-Schichtenstapels 12, 22 Source-/Drain-Implantationen 16a, 16b bzw. 26a, 26b eingebracht sind. Da die MOS-Strukturen 10, 20 nicht als Transistor, sondern als Kondensator betrieben werden sollen, sind die Source-/Drain-Implantationen mit gleichem Dotierungstyp (p oder n) wie die Wannen 15, 25 jedoch wesentlich stärker dotiert. Die Source-/Drain-Implantationen 16a, 16b und die Kondensatorwanne 15 bilden zusammen die erste Elektrode 11 des Kondensators 10. Entsprechendes gilt für den Kondensator 20. Die die dotierte Schicht 13 enthaltende Gateelektrode 12 des Kondensators 10 ist, wie durch das in Figur 5 überlagerte Schaltbild angedeutet, elektrisch mit der Substratelektrode 21 des Kondensators 20 kurzgeschlossen und an den negativen Pol N der Vorspannung V angeschlossen. Die Gateelektrode 22 des Kondensators 20 hingegen mit der Substratelektrode 11 des Kondensators 10 kurzgeschlossen und an den positivem Pol P der Vorspannung V-angeschlossen. Tiefergelegene, sehr hoch dotierte Wannen A1 und A2 ("buried layer") dienen zur starken Reduzierung des relativ hohen Schichtwiderstandes der gleichartig dotierten Wannen 15 und 25, wodurch die Bauelemente eine höhere Seriengüte bekommen und auch in sehr hochfrequenten Schaltungen eingesetzt werden können.

Figur 5A zeigt eine Draufsicht auf die Parallelschaltung zweier Kondensatoren 10, 20 aus Figur 5. Zwei Leiterbahnen 13, 23, die im Bereich der Kondensatoren 10, 20 dort, wo sie zwischen jeweils zwei Source/Drain-Gebieten 11, 11; 21, 21 die zweiten Elektroden mit den jeweils n-dotierten Schichten bilden, besitzen beide die gleiche Breite d. Jedoch besitzen die Source/Drain-Gebiete 11 bzw. 21 in Längsrichtung parallel zur jeweiligen Leiterbahn bzw. zweiten Elektrode 13, 23 unterschiedliche Ausdehnungen L1, L2, wodurch unterschiedlich große Grundflächen A1, A2 der dotierten Schichten der zweiten Elektroden im Bereich der beiden Kondensatoren 10, 20 erzielt werden. In Figur 5A ist die Breite L2 der Source/Drain-Gebiete 21 und somit die Grundfläche A2 der dotierten Schicht, d.h. die Kondensatorplattenfläche größer als beim ersten Transistor 10, wodurch die Kapazität des zweiten Kondensators stärker gewichtet wird. Die dotierten Schichten beider Kondensatoren sind n-dotiert, vorzugsweise mit Phosphor oder Arsen einer Konzentration zwischen 10¹⁷ und 10²¹ Dotierstoffatomen pro Kubikzentimeter. Beide Kondensatoren sind antiparallel miteinander verschaltet; die zweite Elektrode des ersten Kondensators 10 und die erste Elektrode, gebildet aus den beiden Source/Drain-Gebieten 21 und dem Substratbereich in deren Mitte, sind an den negativen Pol N der lokalen Spannungsversorgung V angeschlossen.

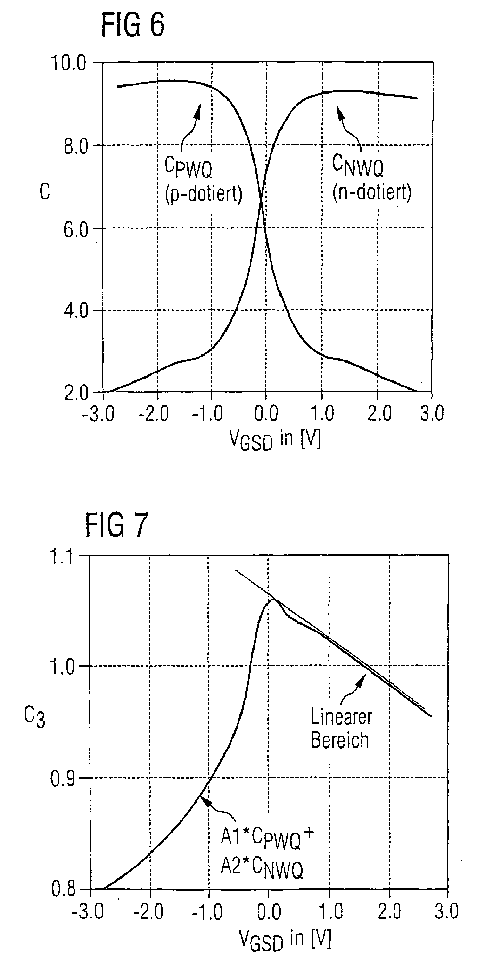

Figur 6 zeigt die Kapazitätskennlinien zweier herkömmlicher MOS Kondensatoren, deren erste Elektrode und deren zweite. Die polykristallines Halbleitermaterial enthaltende Elektrode und die Substratelektrode ist im einen Fall n-dotiert (C_{NWQ}). Im anderen Fall ist die polykristallines Halbleitermaterial enthaltende Elektrode und die Substratelektrode p-dotiert (C_{PWQ}). Eine gewichtete Addition beider Kennlinien führt zur Kennlinie gemäß Figur 7, bei der die erfindungsgemäße Parallelschaltung einen bei positiven Vorspannungen praktisch linearen Verlauf fast bis zu 0,0 Volt besitzt. Die so gebildete Gesamtkapazität kann auch bei Spannungen unterhalb von 0,5 Volt linear betrieben werden, ohne daß Korrekturschaltungen nötig sind.

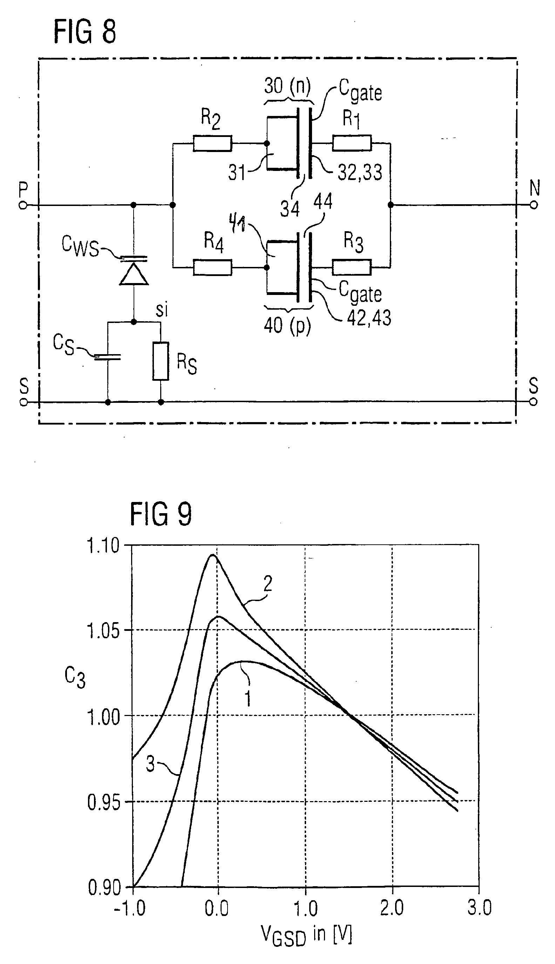

Das Schaltbild dieser Parallelschaltung ist in Figur 8 dargestellt. Die gleichsinnig parallelgeschalteten Kondensatoren 30,40 besitzen Dotierungen ihrer dotierte Schichten 33, 43 unterschiedlichen Dotierungstyps. Die Schicht 33 enthält eine negative Dotierung (n); die Schicht 43 eine positive Dotierung (p). Beide polisiliziumhaltigen zweiten Elektroden 32, 42 sind mit demselben, hier negativen Potential N der Vorspannung verbunden. Bei einem Anschließen der zweiten Elektroden 32, 42 an das positive Potential P wären die Grundflächenverhältnisse der zweiten Elektroden zueinander umzukehren, um die in Figur 7 dargestellten Kennlinien zu erhalten.

Zum Vergleich unterschiedlicher Grundflächenverhältnisse sind in Figur 9 zwei weitere, nicht optimierte Gesamtkennlinien erfindungsgemäßer Parallelschaltungen dargestellt. Der optimale Wert des Grundflächenverhältnisses zwischen dem p-dotierten Kondensator 40 und dem n-dotierten Kondensator 30 beträgt bei diesem Beispiel 0,75. Das optimale Grundflächenverhältnis ist technologieabhängig. In Figur 9 zeigt die Kennlinie 1 den Kapazitätsverlauf bei einem Grundflächenverhältnis von 0,65, die Kurve 2 einen Kennlinienverlauf für ein Grundflächenverhältnis von 0,85. Die Optimierung der Grundflächenverhältnisse führt ersichtlich zu einer weiteren Verbesserung des Kennlinienverlaufs.

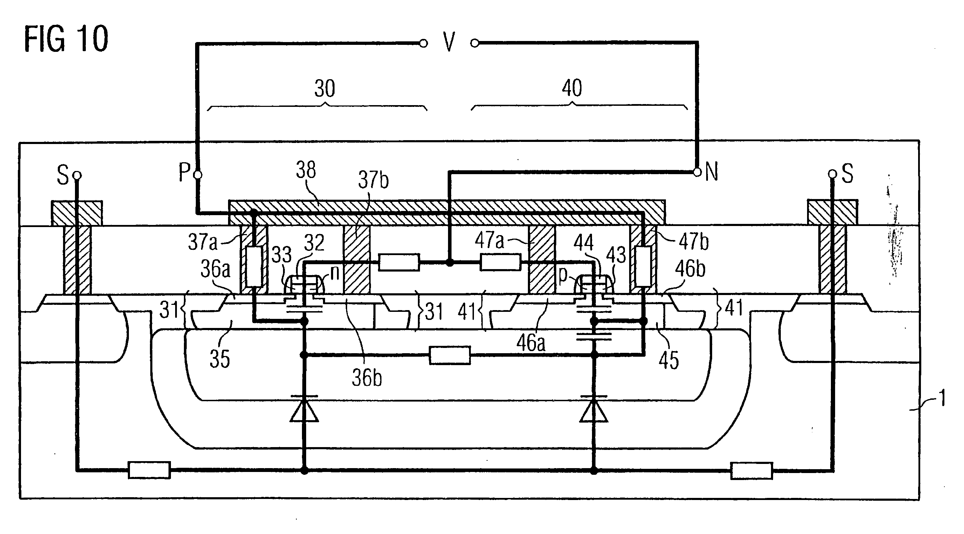

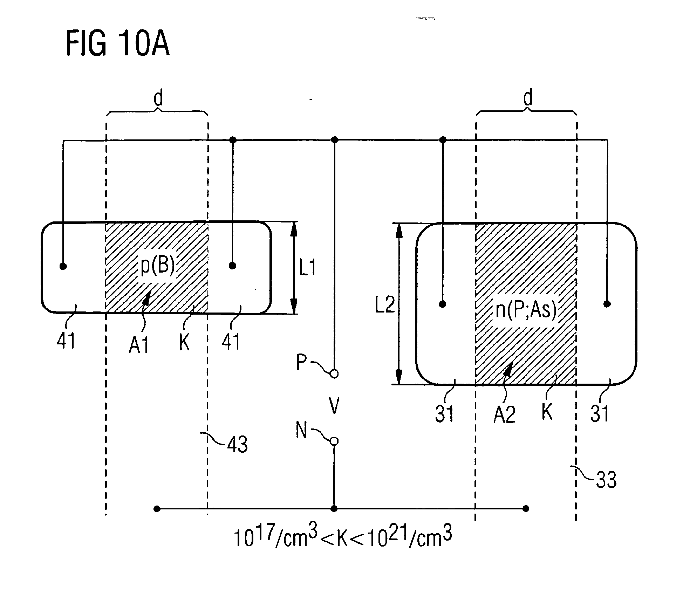

Figur 10 zeigt einen realen Aufbau der erfindungsgemäßen Parallelschaltung zweier MOS-Kondensatoren 30 und 40, die mit denselben Verfahrensschritten wie MOS-Feldeffekttransistoren hergestellt werden können. Die Gate-Schichtenstapel 32 und 42 dienen als obere, zweite Elektrode der Kondensatoren 30, 40 und weisen jeweils eine dotierte Schicht 33 bzw. 43 auf. Unter ihr befindet sich im Substrat jeweils eine wesentlich breitere n-dotierte und p-dotierte Kondensatorwanne 35, 45, in die jeweils rechts und links des jeweiligen Gate-Schichtenstapels 32, 42 Source-/Drain-Implantationen 36a, 36b bzw. 46a, 46b eingebracht sind, die über Kontakte 37a, 37b, 47a und 47b und über eine Leiterbahn 38 kurzgeschlossen sind. Da die MOS-Strukturen 30, 40 nicht als Transistor, sondern als Kondensator betrieben werden sollen, sind die Source-/Drain-Implantationen mit gleichem Dotierungstyp wie die Wannen 35, 45 jedoch wesentlich stärker dotiert. Die Source-/Drain-Implantationen 36a, 36b und die Kondensatorwanne 35 bilden zusammen die erste Elektrode 31 des Kondensators 30. Entsprechendes gilt für den Kondensator 40. Die die dotierte Schicht 33 enthaltende Gateelektrode 32 des Kondensators 30 ist, wie durch das in Figur 10 überlagerte Schaltbild angedeutet, elektrisch mit der Gateelektrode 42 des Kondensators 40 kurzgeschlossen und an den negativen Pol N der Vorspannung V angeschlossen. Die Substratelektrode 41 des Kondensators 40 ist hingegen mit der Substratelektrode 31 des Kondensators 30 kurzgeschlossen und an den positiven Pol P der Vorspannung V angeschlossen. Tiefergelegene Substratwannen A1 und A2 dienen zur Erniedrigung der Wannen-Schichtwiderstände und damit zur Verbesserung der Hochfrequenzeigenschaften. Da Massepotential für das p-dotierte Halbleiter-Grundmaterial wird über die Substrat-Kontaktanschlüsse S bereitgestellt.

Figur 10A zeigt eine Draufsicht auf die integrierte Halbleiterschaltung aus Figur 10. Die Figur 10A entspricht im wesentlichen der Figur 5A, jedoch sind in Figur 10A die dotierten Schichten beider Kondensatoren mit Dotierstoffen unterschiedlichen Leitungstyps p, n dotiert; beispielsweise ist die zweite Elektrode der Grundfläche A1 des ersten Transistors mit Bor dotiert. Ferner sind im Gegensatz zu Figur 5A beide Kondensatoren zueinander parallel geschaltet. Erfindungsgemäß ist auch in Figur 10A die Grundfläche A2 der zweiten Elektrode 33 des zweiten Transistors unterschiedlich groß, insbesondere größer als die Grundfläche A1 der zweiten Elektrode 43 des ersten Kondensators. Die unterschiedlich großen Grundflächen A1, A2 werden vorzugsweise durch unterschiedliche Ausdehnungen L1, L2 der an die Leiterbahnen für die zweiten Elektroden 33, 43 angrenzenden Source/Drain-Gebiete 31, 41 in Längsrichtung dieser Leiterbahnen erreicht. Dadurch kann für beide Kondensatoren eine einheitliche Gate-Breite d gewählt werden.

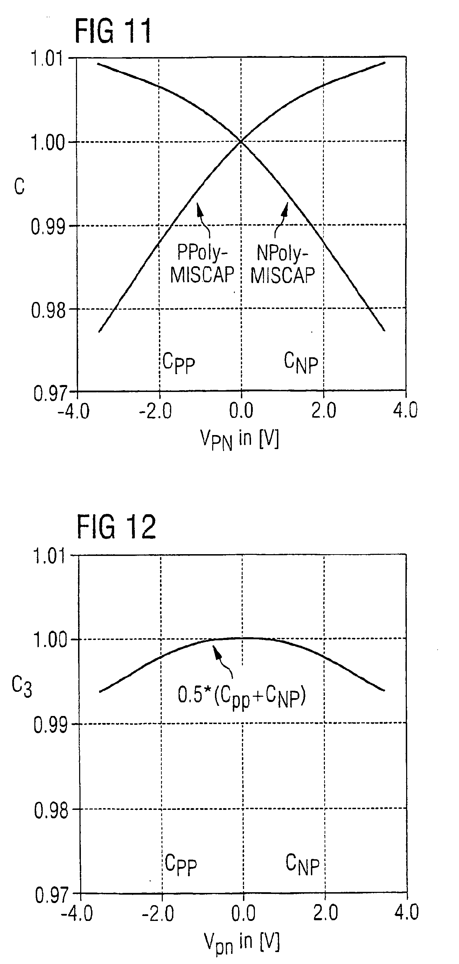

Figur 11 zeigt die Kennlinien von in MIS-Technologie hergestellten Kondensatoren, die als Dielektrikum jeweils eine Oxid-Nitrid-Oxid-Schichtenfolge aufweisen, deren teilweisepolykristalline Halbleiterelektrode in einem Fall n-dotiert, im anderen Fall p-dotiert ist. Beide Einzelkennlinien besitzen signifikante absolute Steigungen a und haben meist eine nichtlineare Spannungsabhängigkeit der Form C=C₀*(1+a*V +b*V² +c V³). b ist der Koeffizient für quadratische Spannungsabhängigkeit und c ist der Koeffizient für eventuelle Spannungsabhängigkeit dritter Ordnung.

Werden zwei solche MIS-Kondensatoren unterschiedlichen Dotierungstyps zueinander parallelgeschaltet, ergibt sich die in Figur 12 dargestellte Kennlinie. Sie besitzt ein Maximum bei einer Vorspannung von 0,0 Volt und besitzt bei dieser Spannung keine lineare Abhängigkeit der Kapazität von der Vorspannung. Bei dieser Ausführungsform wird nicht die quadratische, sondern die lineare Abhängigkeit der Gesamtkapazität von der angelegten Spannung durch eine geeignete Parallelschaltung zweier Kondensatoren beseitigt; die Kapazität C3 ist bei einer Spannung von etwa 0,0 Volt annähernd konstant. Ist der lineare Term der Spannungsabhängigkeit aₚ bei MIS-Kondensatoren mit p-dotierter polykristalliner Halbleiterelektrode nicht nur im Vorzeichen, sondern auch im Betrag unterschiedlich zum linearen Term der Spannungsabhängigkeit aₙ (bei MIS-Kondensatoren mit n-dotierter polykristalliner Halbleiterelektrode), so kann auch hier durch unterschiedliche Gewichtungen der Flächen Aₚ/Aₙ=aₙ/aₚ der lineare Term immer eliminiert werden. Anstelle des linearen Terms kann jedoch auch die quadratische Abhängigkeit oder eine Abhängigkeit höherer Ordnung kompensiert werden.

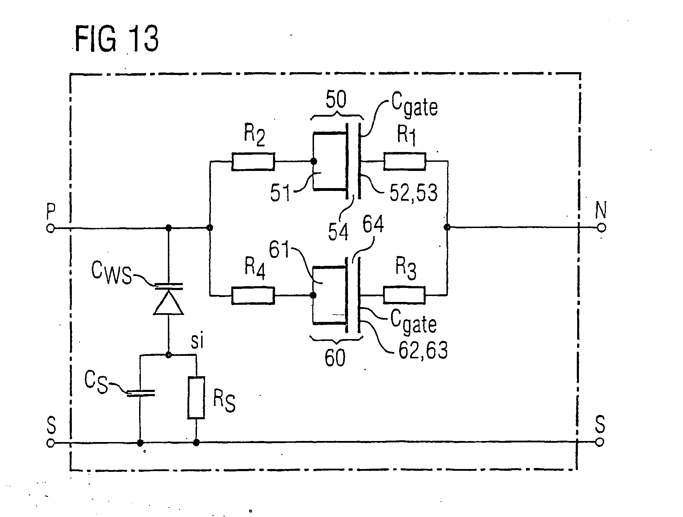

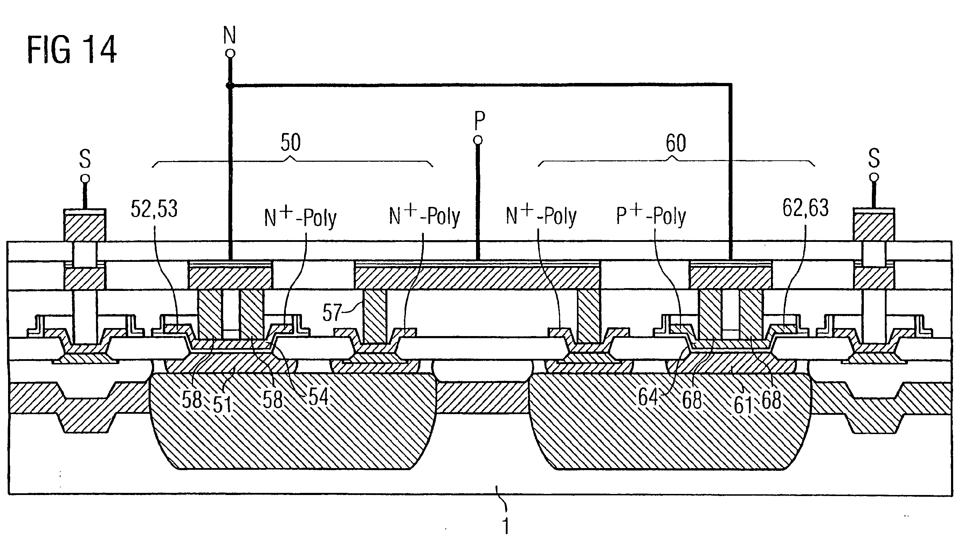

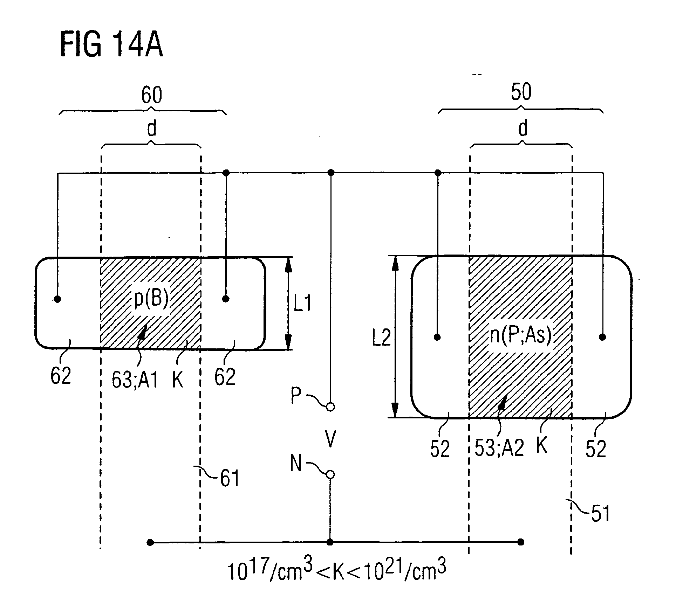

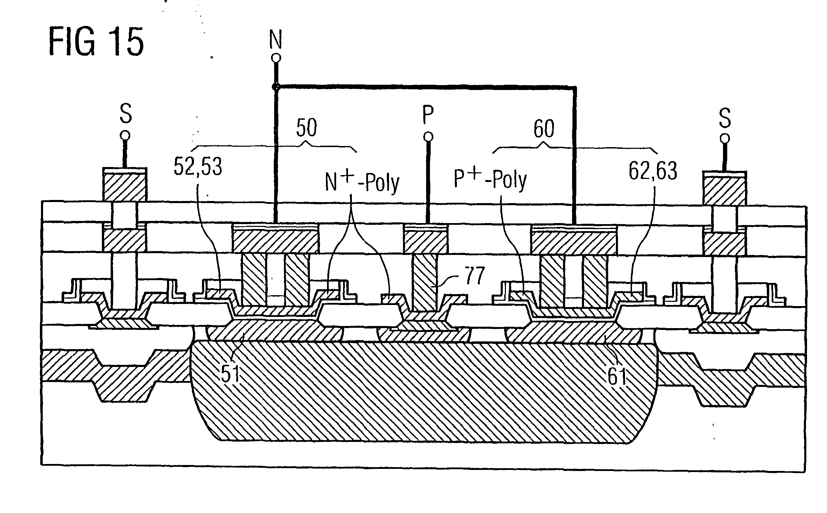

Das dieser Parallelschaltung entsprechende Schaltbild ist in Figur 13 dargestellt. Die oberhalb der Oxid-Nitrid-Oxid-Schichtenfolge 54, 64 der MIS-Kondensatoren 50, 60 angeordneten dotierten Schichten 52, 62 sind beide miteinander kurzgeschlossen und mit dem negativen Potential N der Vorspannung V verbunden. Die technologische Realisierung dieses Schaltbildes ist beispielhaft in den Figuren 14 und 15 dargestellt.

Figur 14 zeigt zwei Kondensatoren 50, 60 in MIS-Technologie, die jeweils eine erste Elektrode 51, 61, eine dielektrische Oxid-Nitrid-Oxid-Schichtenfolge 54, 64 und eine zweite Elektrode 52, 62 mit einer Polisiliziumschicht 53, 63 aufweisen. Die Substratelektroden 51, 61 sind über tiefergelegene Wannen und lateral versetzte Wannen an Kontakte 57, 67 angeschlossen, die mit dem positiven Potential P der Vorspannung V verbunden sind. Die Gateelektroden 52, 62 sind jeweils über ein Gitter von Kontakten 58, 68 mit dem negativen Potential N verbunden. Die Anzahl der Kontakte 58, 68 hängt von der Größe der realisierten Kapazitätsfläche ab.

Figur 14A zeigt eine Draufsicht auf die Halbleiterschaltung aus Figur 14. Die Figur 14A entspricht im wesentlichen der Figur 10A, jedoch sind in Figur 14A die dotierten Schichten 53, 63 im Halbleitersubstrat angeordnet, während die ersten Elektroden 51, 61 über dem Substrat in Form von Leiterbahnabschnitten jeweils der Breite d ausgebildet sind. Die in der Substratelektrode 52; 62 ausgebildeten dotierten Schichten 53, 63 der beiden Kondensatoren 50, 60 besitzen unterschiedlich große Grundflächen A1, A2, entsprechend unterschiedlich großen Ausdehnungen L1, L2 der jeweiligen Substratelektrode 52, 62 entlang der Leiterbahnen für die ersten Elektroden 51, 61. In Figur 14A sind die dotierten Schichten mit Dotierstoffen entgegengesetzten Ladungsträgertyps dotiert, und beide Kondensatoren sind zueinander parallel geschaltet.

Da bei dieser Ausführungsform die Substratelektroden 51, 61 beider Kondensatoren an denselben gemeinsamen Elektrodenanschluß P angeschlossen sind, läßt sich die in Figur 14 dargestellte Bauweise vereinfachen, wie in Figur 15 dargestellt. Dort sind die Substratelektroden 51, 61 in einer gemeinsamen Substratwanne angeordnet, die über eine Anschlußwanne mit dem Anschlußkontakt 77 verbunden ist, der zu dem positiven Potential P der Vorspannung führt.

Werden in den Figuren 14 und 15 anstelle dotierter Polysiliziumelektroden nicht-polykristalline, insbesondere metallische obere Elektroden eingesetzt, wo kann ein dem Poly-Depletion-Effekt entsprechender Effekt dennoch weiterhin auftreten, und zwar aufgrund von Vorgängen in den dotierten Substratelektroden. In diesem Fall sind zweiten Elektroden die Substratelektroden, und ihre dotierten Schichten sind im Halbleitersubstrat angeordnet. Auch bei diesen Zukunftstechnologien kann anstelle der in-den Figuren 14 und 15 eine gegensinnige Parallelschaltung mit zueinander entgegengesetztem Dotierungstyp der Dotierungen der dotierten Schichten der zweiten Elektroden eingesetzt werden, bei der die Substratelektrode des einen Kondensators positiv und die des anderen Kondensators negativ dotiert ist.

Mithilfe der vorliegenden Erfindung können Kondensatoren, die herkömmlich aufgrund eines spannungsabhängigen Verlaufs ihrer Kapazitätskennlinie nur eingeschränkt oder nur in Verbindung mit Kompensationsschaltungen eingesetzt werden können, ohne solche Schaltungen universeller verwendet werden. Die erfindungsgemäße Parallelschaltung ermöglicht eine Anpassung der Kapazitätskennlinie an den jeweils gewünschten Kennlinienverlauf. In der erfindungsgemäßen Parallelschaltung können beliebig große Kapazitäten kombiniert werden, nicht nur solche mit kleinen Gate-Längen des Ein- bis Zweifachen der optischen Auslösungsgrenze, sondern auch sehr große Gate-Längen mit dem Vier- bis 40-fachen der optischen Auflösungsgrenze. Hohe flächenspezifische Kapazitäten und hohe Seriengüten, die durch Weglassen von LDD-Implantationen noch verbessert werden können, ermöglichen insbesondere den Einsatz in Mobilfunkschaltungen.

### Bezugszeichenliste:

- 1: Halbleitersubstrat
- 10, 30: erster (MOS)-Kondensator
- 20, 40: zweiter (MOS)-Kondensator
- 50: erster (MIS)-Kondensator
- 60: zweiter (MIS)-Kondensator
- 11, 21, 31, ..., 61: erste Elektroden
- 12, 22, 32, ..., 62: zweite Elektroden
- 13, 23, 33, ..., 63: dotierte Schicht
- 14, 24, 34, ..., 64: Dielektrikum
- 17, 27, 37, ..., 67: Wannenanschlüsse
- A1: Grundfläche des ersten Kondensators
- A2: Grundfläche des zweiten Kondensators
- P, N: gemeinsame Elektrodenanschlüsse
- S: Substratanschluß (Bulk)
- K: Konzentration

## Patentansprüche

1. Integrierte Halbleiterschaltung, die Kondensatoren (10, 20; 30, 40; 50, 60) aufweist, die jeweils
- eine erste Elektrode (11, 21; 31, 41; 51, 61),
- eine zweite Elektrode (12, 22; 32, 42; 52, 62) mit einer dotierten Schicht (13, 23; 33, 43; 53, 63) und
- jeweils ein Dielektrikum (14, 24; 34, 44; 54, 64) zwischen der ersten und der zweiten Elektrode
aufweisen,
- wobei jeweils eine der beiden Elektroden eines Kondensators (10, 20; 30, 40; 50, 60) als Substratelektrode und die andere Elektrode des Kondensators als Leiterbahnabschnitt ausgebildet ist,
- wobei die Halbleiterschaltung eine Parallelschaltung zweier Kondensatoren (10, 20; 30, 40; 50, 60) aufweist, bei der je eine Elektrode (11, 22; 31, 41; 52, 62) des ersten Kondensators (10; 30; 50) und des zweiten Kondensators (20; 40; 60) durch einen ersten gemeinsamen Elektrodenanschluß (P) miteinander kurzgeschlossen sind und bei der die jeweils anderen Elektroden (12, 21; 32, 42; 51, 61) des ersten (10; 30; 50) und des zweiten Kondensators (20; 40; 60) durch einen zweiten gemeinsamen Elektrodenanschluß (N) miteinander kurzgeschlossen sind, und
- wobei die dotierten Schichten (13, 23) beider Kondensatoren (10, 20) mit Dotierstoffen desselben Dotierungstyps (n) dotiert sind und der erste Kondensator (10) und der zweite Kondensator- (20) gegensinnig parallelgeschaltet sind, so daß die dotierte Schicht (30) des einen Kondensators (10) an den einen gemeinsamen Elektrodenanschluß (N) und die dotierte Schicht (23) des anderen Kondensators (20) an den anderen gemeinsamen Elektrodenanschluß (P) angeschlossen ist,
**dadurch gekennzeichnet, daß**
die Grundflächen (A1, A2) der dotierten Schichten (13, 23; 33, 43; 53, 63) des ersten Kondensators (10; 30; 50) und des zweiten Kondensators (20; 40; 60) unterschiedlich groß gestaltet sind, indem die Substratelektroden (11, 21; 31, 41; 52, 62) in Längsrichtung der durch die anderen Elektroden (12, 22; 32, 42; 51, 61) gebildeten Leiterbahnabschnitte unterschiedlich große Ausdehnungen (L1, L2) besitzen.

2. Integrierte Halbleiterschaltung, die Kondensatoren (10, 20; 30, 40; 50, 60) aufweist, die jeweils
- eine erste Elektrode (11, 21; 31, 41; 51, 61),
- eine zweite Elektrode (12, 22; 32, 42; 52, 62) mit einer dotierten Schicht (13, 23; 33, 43; 53, 63) und
- jeweils ein Dielektrikum (14, 24; 34, 44; 54, 64) zwischen der ersten und der zweiten Elektrode
aufweisen,
- wobei jeweils eine der beiden Elektroden eines Kondensators (10, 20; 30, 40; 50, 60) als Substratelektrode und die andere Elektrode des Kondensators als Leiterbahnabschnitt ausgebildet ist,
- wobei die Halbleiterschaltung eine Parallelschaltung zweier Kondensatoren (10, 20; 30, 40; 50, 60) aufweist, bei der je eine Elektrode (11, 22; 31, 41; 52, 62) des ersten Kondensators (10; 30; 50) und des zweiten Kondensators (20; 40; 60) durch einen ersten gemeinsamen Elektrodenanschluß (P) miteinander kurzgeschlossen sind und bei der die jeweils anderen Elektroden (12, 21; 32, 42; 51, 61) des ersten (10; 30; 50) und des zweiten Kondensators (20; 40; 60) durch einen zweiten gemeinsamen Elektrodenanschluß (N) miteinander kurzgeschlossen sind, und
- wobei die dotierte Schicht (33; 53) des einen Kondensators (30; 50) n-dotiert und die dotierte Schicht (43; 63) des anderen Kondensators (40; 60) p-dotiert ist und die beiden Kondensatoren (30, 40; 50, 60) gleichsinnig parallelgeschaltet sind, so daß beide dotierten Schichten (33, 43; 53, 63) durch einen gemeinsamen Elektrodenanschluß miteinander kurzgeschlossen sind.
**dadurch gekennzeichnet, daß**
die Grundflächen (A1, A2) der dotierten Schichten (13, 23; 33, 43; 53, 63) des ersten Kondensators (10; 30; 50) und des zweiten Kondensators (20; 40; 60) unterschiedlich groß gestaltet sind, indem die Substratelektroden (11, 21; 31, 41; 52, 62) in Längsrichtung der durch die anderen Elektroden (12, 22; 32, 42; 51, 61) gebildeten Leiterbahnabschnitte unterschiedlich große Ausdehnungen-(L1, L2) besitzen.

3. Halbleiterschaltung nach Anspruch 1 oder 2,
**dadurch gekennzeichnet, daß**
die Grundflächen (A1, A2) beider dotierten Schichten (13, 23; 33, 43; 53, 63) ein Flächenverhältnis von zwischen 0,2 und 5,0 besitzen.

4. Halbleiterschaltung nach Anspruch 2 oder 3,
**dadurch gekennzeichnet, daß**
die Grundfläche (A1) der p-dotierten Schicht (43; 63) kleiner ist als-die-Grundfläche (A2) der n-dotierten Schicht (33; 53).

5. Halbleiterschaltung nach Anspruch 4,
**dadurch gekennzeichnet, daß**
die Grundfläche (A1) der p-dotierten Schicht (43; 63) zwischen 65 % und 85 % der Grundfläche (A2) der n-dotierten Schicht (33; 53) beträgt.

6. Halbleiterschaltung nach einem der Ansprüche 1 bis 5,
**dadurch gekennzeichnet, daß**
die dotierten Schichten (13, 23; 33, 43; 53, 63) der zweiten Elektroden (12, 22; 32, 42; 52, 62) der beiden Kondensatoren (10, 20; 30, 40; 50, 60) mit Dotierstoffen in Konzentrationen (K) zwischen 10¹⁷/cm³ und 10²¹/cm³ dotiert sind.

7. Halbleiterschaltung nach einem der Ansprüche 1 bis 6,
**dadurch gekennzeichnet, daß**
die dotierten Schichten (13, 23; 33, 43; 53, 63) der zweiten Elektroden (12, 22; 32, 42; 52, 62) der beiden Kondensatoren (10, 20; 30, 40; 50, 60) mit Bor, Phosphor oder Arsen dotiert sind.

8. Halbleiterschaltung nach einem der Ansprüche 1 bis 7,
**dadurch gekennzeichnet, daß**
die dotierten Schichten (13, 23; 33, 43; 53, 63) der zweiten Elektroden (12, 22; 32, 42; 52, 62) des ersten (10; 30; 50) und des zweiten Kondensators (20; 40; 60) polykristalline Schichten, insbesondere Polysiliziumschichten sind.

9. Halbleiterschaltung nach einem der Ansprüche 1 bis 8,
**dadurch gekennzeichnet , daß**
die ersten Elektroden (11, 21; 31, 41; 51, 61) des ersten (10; 30; 50) und des zweiten Kondensators (20; 40; 60) dotierte Gebiete eines Halbleitersubstrats (1) sind.

10. Halbleiterschaltung nach einem der Ansprüche 1 bis 9,
**dadurch gekennzeichnet, daß**
die dielektrischen Schichten (54, 64)-des ersten (50) und des zweiten Kondensators (60) ein Nitrid enthalten.

11. Halbleiterschaltung nach einem der Ansprüche 1 bis 9,
**dadurch gekennzeichnet, daß**
die dielektrischen Schichten (14, 24; 34, 44) des ersten (10; 30) und des zweiten Kondensators (20; 40) auf einem Halbleitersubstrat (1) angeordnete Oxidschichten sind und daß beim ersten Kondensator (10; 30) und beim zweiten Kondensator (20; 40) die erste Elektrode (11, 21; 31, 41) jeweils eine unterhalb der Oxidschicht (14, 24; 34, 44) des Kondensators (10, 20; 30, 40) im Substrat angeordnete dotierte Wanne (15, 25; 35, 45) aufweist, in die auf zwei gegenüberliegenden Seiten der Grundfläche der zweiten Elektrode (12, 22; 32, 42) zwei Implantationsgebiete (16a, 16b; 26a, 26b) eingebracht sind, die eine Dotierung gleichen Dotierungstyps wie die Wanne (15, 25; 35, 45), aber höherere Dotierungskonzentration aufweisen und die mit der Substratwanne (15, 25; 35, 45) und miteinander elektrisch kurzgeschlossen sind.

12. Halbleiterschaltung nach einem der Ansprüche 1 bis 11,
**dadurch gekennzeichnet, daß**
das Verhältnis der Grundflächen der dotierten Schichten (13, 23; 33, 43; 53, 63) des ersten (10; 30; 50) und des zweiten Kondensators (20; 40; 60) so gewählt ist, daß die Parallelschaltung eine Gesamtkapazität (C₃) besitzt, die über einen Bereich variabler Vorspannungen (V) linear verläuft.

13. Halbleiterschaltung nach einem der Ansprüche 1 bis-7,
**dadurch gekennzeichnet, daß**
die zweiten Elektroden (52, 62) des ersten (50) und des zweiten Kondensators (60) Substratelektroden sind und daß die dotierten Schichten (53, 63) der zweiten Elektroden (52, 62) im Halbleitersubstrat (1) angeordnet sind.

## Claims

1. Integrated semiconductor circuit having capacitors (10, 20; 30, 40; 50, 60) each having
- a first electrode (11, 21; 31, 41; 51, 61),
- a second electrode (12, 22; 32, 42; 52, 62) with a doped layer (13, 23; 33, 43; 53, 63) and
- in each case a dielectric (14, 24; 34, 44; 54, 64) between the first and the second electrode,
- wherein in each case one of the two electrodes of a capacitor (10, 20; 30, 40; 50, 60) is embodied as a substrate electrode and the other electrode of the capacitor is embodied as an interconnect section,
- wherein the semiconductor circuit has a parallel connection of two capacitors (10, 20; 30, 40; 50, 60) in which a respective electrode (11, 22; 31, 41; 52, 62) of the first capacitor (10; 30; 50) and of the second capacitor (20; 40; 60) are short-circuited with one another by a first common electrode connection (P) and in which the respective other electrodes (12, 21; 32, 42; 51, 61) of the first capacitor (10; 30; 50) and of the second capacitor (20; 40; 60) are short-circuited with one another by a second common electrode connection (N), and
- wherein the doped layers (13, 23) of both capacitors (10, 20) are doped with dopants of the same doping type (n) and the first capacitor (10) and the second capacitor (20) are connected in parallel in opposite directions, such that the doped layer (30) of one capacitor (10) is connected to one common electrode connection (N) and the doped layer (23) of the other capacitor (20) is connected to the other common electrode connection (P),
**characterized in that**
the basic areas (A1, A2) of the doped layers (13, 23; 33, 43; 53, 63) of the first capacitor (10; 30; 50) and of the second capacitor (20; 40; 60) are configured with different magnitudes by virtue of the substrate electrodes (11, 21; 31, 41; 52, 62) having extents (L1, L2) of different magnitudes in the longitudinal direction of the interconnect sections formed by the other electrodes (12, 22; 32, 42; 51, 61).

2. Integrated semiconductor circuit having capacitors (10, 20; 30, 40; 50, 60) each having
- a first electrode (11, 21; 31, 41; 51, 61),
- a second electrode (12, 22; 32, 42; 52, 62) with a doped layer (13, 23; 33, 43; 53, 63) and
- in each case a dielectric (14, 24; 34, 44; 54, 64) between the first and the second electrode,
- wherein in each case one of the two electrodes of a capacitor (10, 20; 30, 40; 50, 60) is embodied as a substrate electrode and the other electrode of the capacitor is embodied as an interconnect section,
- wherein the semiconductor circuit has a parallel connection of two capacitors (10, 20; 30, 40; 50, 60) in which a respective electrode (11, 22; 31, 41; 52, 62) of the first capacitor (10; 30; 50) and of the second capacitor (20; 40; 60) are short-circuited with one another by a first common electrode connection (P) and in which the respective other electrodes (12, 21; 32, 42; 51, 61) of the first capacitor (10; 30; 50) and of the second capacitor (20; 40; 60) are short-circuited with one another by a second common electrode connection (N), and
- wherein the doped layer (33; 53) of one capacitor (30; 50) is n-doped and the doped layer (43; 63) of the other capacitor (40; 60) is p-doped and the two capacitors (30, 40; 50, 60) are connected in parallel in the same direction, such that both doped layers (33, 43; 53, 63) are short-circuited with one another by a common electrode connection,
**characterized in that**
the basic areas (A1, A2) of the doped layers (13, 23; 33, 43; 53, 63) of the first capacitor (10; 30; 50) and of the second capacitor (20; 40; 60) are configured with different magnitudes by virtue of the substrate electrodes (11, 21; 31, 41; 52, 62) having extents (L1, L2) of different magnitudes in the longitudinal direction of the interconnect sections formed by the other electrodes (12, 22; 32, 42; 51, 61).

3. Semiconductor circuit according to Claim 1 or 2,
**characterized in that**
the basic areas (A1, A2) of the two doped layers (13, 23; 33, 43; 53, 63) have an area ratio of between 0.2 and 5.0.

4. Semiconductor circuit according to Claim 2 or 3,
**characterized in that**
the basic area (A1) of the p-doped layer (43; 63) is smaller than the basic area (A2) of the n-doped layer (33; 53).

5. Semiconductor circuit according to Claim 4,
**characterized in that**
the basic area (A1) of the p-doped layer (43; 63) is between 65% and 85% of the basic area (A2) of the n-doped layer (33; 53).

6. Semiconductor circuit according to any of Claims 1 to 5,
**characterized in that**
the doped layers (13, 23; 33, 43; 53, 63) of the second electrodes (12, 22; 32, 42; 52, 62) of the two capacitors (10, 20; 30, 40; 50, 60) are doped with dopants in concentrations (K) of between 10¹⁷/cm³ and 10²¹/cm³.

7. Semiconductor circuit according to any of Claims 1 to 6,
**characterized in that**
the doped layers (13, 23; 33, 43; 53, 63) of the second electrodes (12, 22; 32, 42; 52, 62) of the two capacitors (10, 20; 30, 40; 50, 60) are doped with boron, phosphorus or arsenic.

8. Semiconductor circuit according to any of Claims 1 to 7,
**characterized in that**
the doped layers (13, 23; 33, 43; 53, 63) of the second electrodes (12, 22; 32, 42; 52, 62) of the first capacitor (10; 30; 50) and of the second capacitor (20; 40; 60) are polycrystalline layers, in particular polysilicon layers.

9. Semiconductor circuit according to any of Claims 1 to 8,
**characterized in that**
the first electrodes (11, 21; 31, 41; 51, 61) of the first capacitor (10; 30; 50) and of the second capacitor (20; 40; 60) are doped regions of a semiconductor substrate (1).

10. Semiconductor circuit according to any of Claims 1 to 9,
**characterized in that**
the dielectric layers (54, 64) of the first capacitor (50) and of the second capacitor (60) contain a nitride.

11. Semiconductor circuit according to any of Claims 1 to 9,
**characterized in that**
the dielectric layers (14, 24; 34, 44) of the first capacitor (10; 30) and of the second capacitor (20; 40) are oxide layers arranged on a semiconductor substrate (1), and
**in that** in the case of the first capacitor (10; 30) and in the case of the second capacitor (20; 40), the first electrode (11, 21; 31, 41) has in each case a doped well (15, 25; 35, 45) arranged below the oxide layer (14, 24; 34, 44) of the capacitor (10, 20; 30, 40) in the substrate, into which doped well are introduced, on two opposite sides of the basic area of the second electrode (12, 22; 32, 42) two implantation regions (16a, 16b; 26a, 26b) which have a doping of the same doping type as the well (15, 25; 35, 45) but a higher doping concentration and which are electrically short-circuited with the substrate well (15, 25; 35, 45) and with one another.

12. Semiconductor circuit according to any of Claims 1 to 11,
**characterized in that**
the ratio of the basic areas of the doped layers (13, 23; 33, 43; 53, 63) of the first capacitor (10; 30; 50) and of the second capacitor (20; 40; 60) is chosen in such a way that the parallel connection has a total capacitance (C₃) which has a linear profile over a range of variable bias voltages (V).

13. Semiconductor according to any of Claims 1 to 7,
**characterized in that**
the second electrodes (52, 62) of the first capacitor (50) and of the second capacitor (60) are substrate electrodes, and **in that** the doped layers (53, 63) of the second electrodes (52, 62) are arranged in the semiconductor substrate (1).

## Revendications

1. Circuit à semi-conducteur intégré, qui a des condensateurs (10, 20 ; 30, 40 ; 50, 60), lesquels ont respectivement .
- une première électrode (11, 21 ; 31, 41 ; 51, 61),
- une deuxième électrode (12, 22 ; 32, 42 ; 52, 62) ayant une couche (13, 23 ; 33, 43 ; 53, 63) dopée et
- respectivement un diélectrique (14, 24 ; 34, 44 ; 54, 64) entre la première et la deuxième électrode,
- dans lequel respectivement l'une des deux électrodes d'un condensateur (10, 20 ; 30, 40 ; 50, 60) est constituée sous la forme d'une électrode de substrat et l'autre électrode du condensateur sous la forme d'un segment de piste conductrice,
- dans lequel le circuit à semi-conducteur a un circuit parallèle de deux condensateurs (10, 20 ; 30, 40 ; 50, 60), dans lequel respectivement une électrode (11, 22 ; 31, 41 ; 52, 62) du premier condensateur (10 ; 30 ; 50) et du deuxième condensateur (20 ; 40 ; 60) sont court-circuitées entre elles par une première borne (P) d'électrode commune et dans lequel les autres électrodes (12, 21 ; 32, 42 ; 51, 61) du premier (10 ; 30 ; 50) et du deuxième (20 ; 40 ; 60) condensateurs sont court-circuitées entre elles par une deuxième borne (N) d'électrode commune, et
- dans lequel les couches (13, 23) dopées des deux condensateurs (10, 20) sont dopées par des substances de dopage du même type (n) de dopage et le premier condensateur (10) et le deuxième condensateur (20) sont montés en parallèle en sens opposé, de sorte que la couche (30) dopée du premier condensateur (10) est reliée à l'une des bornes (N) d'électrode communes et que la couche (23) dopée de l'autre condensateur (20) est reliée à l'autre borne (P) d'électrode commune, **caractérisé en ce que** les surfaces (A1, A2) de base des couches (13, 23 ; 33, 43 ; 53, 63) dopées du premier condensateur (10 ; 30 ; 50) et du deuxième condensateur (20 ; 40 ; 60) sont différemment grandes par le fait que les électrodes (11, 21 ; 31, 41 ; 52, 62) de substrat ont des étendues (L1, L2) différemment grandes dans la direction longitudinale des segments de piste conductrice formés par les autres électrodes (12, 22 ; 32, 42 ; 51, 61).

2. Circuit à semi-conducteur intégré, qui a des condensateurs (10, 20 ; 30, 40 ; 50, 60), lesquels ont respectivement
- une première électrode (11, 21 ; 31, 41 ; 51, 61),
- une deuxième électrode (12, 22 ; 32, 42 ; 52, 62) ayant une couche (13, 23 ; 33, 43 ; 53, 63) dopée et
- respectivement un diélectrique (14, 24 ; 34, 44 ; 54, 64) entre la première et la deuxième électrode
- dans lequel respectivement l'une des deux électrodes d'un condensateur (10, 20 ; 30, 40 ; 50, 60) est constituée sous la forme d'une électrode de substrat et l'autre électrode du condensateur sous la forme d'un segment de piste conductrice,
- dans lequel le circuit à semi-conducteur a un circuit parallèle de deux condensateurs (10, 20 ; 30, 40 ; 50, 60), dans lequel respectivement une électrode (11, 22 ; 31, 41 ; 52, 62) du premier condensateur (10 ; 30 ; 50) et du deuxième condensateur (20 ; 40 ; 60) sont court-circuitées entre elles par une première borne (P) d'électrode commune et dans lequel les autres électrodes (12, 21 ; 32, 42 ; 51, 61) du premier (10 ; 30 ; 50) et du deuxième (20 ; 40 ; 60) condensateurs sont court-circuitées entre elles par une deuxième borne (N) d'électrode commune, et
dans lequel la couche (33, 53) dopée de l'un des condensateurs (30, 50) est à dopage n et la couche (43, 53) dopée de l'autre condensateur (40, 60) est à dopage p et les deux condensateurs (30, 40 ; 50, 60) sont montés en parallèle dans le même sens de sorte que les deux couches (33, 43 ; 53, 63) dopées sont court-circuitées entre elles par une borne d'électrode commune
**caractérisé en ce que** les surfaces (A1, A2) de base des ouches (13, 23 ; 33, 43 ; 53, 63) dopées du premier condensateur (10 ; 30 ; 50) et du deuxième condensateur (20 ; 40 ; 60) sont différemment grandes par le fait que les électrodes (11, 21 ; 31, 41 ; 52, 62) de substrat ont des étendues (L1, L2) différemment grandes dans la direction longitudinale des segments de piste conductrice formés par les autres électrodes (12, 22 ; 32, 42 ; 51, 61) .

3. Circuit suivant la revendication 1 ou 2,
**caractérisé en ce que** les surfaces (A1, A2) de base des deux couches (13, 23 ; 33, 43 ; 53, 63) dopées ont un rapport de surface compris entre 0,2 et 5,0.

4. Circuit suivant la revendication 2 ou 3,
**caractérisé en ce que** la surface (A1) de base de la couche (43 ; 63) à dopage p est plus petite que la surface (A2) de base de la couche (33 ; 53) à dopage n.

5. Circuit suivant la revendication 4,
**caractérisé en ce que** la surface (A1) de base de la couche (43 ; 63) à dopage p représente de 65 % à 85 % de la surface (A2) de base de la couche (33 ; 53) à dopage n.

6. Circuit suivant l'une des revendications 1 à 5,
**caractérisé en ce que** les couches (13, 23 ; 33, 43 ; 53, 63) dopées des deuxièmes électrodes (12, 22 ; 32, 42 ; 52, 62) des deux condensateurs (10, 20 ; 30, 40 ; 50, 60) sont dopées par des substances de dopage en des concentrations (K) comprise entre 10¹⁷/cm³ et 10²¹/cm³.

7. Circuit suivant l'une des revendications 1 à 6,
**caractérisé en ce que** les couches (13, 23 ; 33, 43 ; 53, 63) dopées des deuxièmes électrodes (12, 22 ; 32, 42 ; 52, 62) des deux condensateurs (10, 20 ; 30, 40 ; 50, 60) sont dopées par du bore, par du phosphore ou par de l'arsenic.

8. Circuit suivant l'une des revendications 1 à 7,
**caractérisé en ce que** les couches (13, 23 ; 33, 43 ; 53, 63) dopées des deuxièmes électrodes (12, 22 ; 32, 42 ; 52, 62) du premier (10 ; 30 ; 50) et du deuxième (20 ; 40 ; 60) condensateurs sont des couches polycristallines, notamment des couches de polysilicium.

9. Circuit suivant l'une des revendications 1 à 8,
**caractérisé en ce que** les premières électrodes (11, 21 ; 31, 41 ; 51, 61) du premier (10 ; 30 ; 50) et du deuxième (20 ; 40 ; 60) condensateurs sont des zones dopées d'un substrat (1) semi-conducteur.

10. Circuit suivant l'une des revendications 1 à 9,
**caractérisé en ce que** les couches (54, 64) diélectriques du premier (50) et du deuxième (60) condensateurs contiennent un nitrure.

11. Circuit suivant l'une des revendications 1 à 9,
**caractérisé en ce que** les couches (14, 24 ; 34, 44) diélectriques du premier (10 ; 30) et du deuxième (20 ; 40) condensateurs sont des couches d'oxyde et disposées sur un substrat (1) semi-conducteur et **en ce que**, pour le premier condensateur (10 ; 30) et pour le deuxième condensateur (20 ; 40), la première électrode (11, 21 ; 31, 41) a respectivement un caisson (15, 25 ; 35, 45) dopé disposé dans le substrat sous la couche (14, 24 ; 34, 44) d'oxyde du condensateur (10, 20 ; 30, 40), caisson dans lequel sont introduites sur deux côtés opposés de la surface de base de la deuxième électrode (12, 22 ; 32, 42) deux zones (16a, 16b ; 26a, 26b) d'implantation qui ont un dopage de même type de dopage que le caisson (15, 25 ; 35, 45) mais en une concentration de dopage plus grande et qui sont court-circuitées électriquement l'une avec l'autre et avec le caisson (15, 25 ; 35, 45) de substrat.

12. Circuit suivant l'une des revendications 1 à 11,
**caractérisé en ce que** le rapport des surfaces de base des couches (13, 23 ; 33, 43 ; 53, 63) dopées du premier (10 ; 30 ; 50) et du deuxième (20 ; 40 ; 60) condensateurs est choisi de façon à ce que le circuit parallèle ait une capacité (C₃) globale qui s'étend linéairement sur une plage de tensions (V) de polarisation variables.

13. Circuit suivant l'une des revendications 1 à 7,
**caractérisé en ce que** les deuxièmes électrodes (52, 62) du premier (50) et du deuxième (60) condensateurs sont des électrodes de substrat et **en ce que** les couches (53, 63) dopées des deuxièmes électrodes (52, 62) sont disposées dans le substrat (1) semi-conducteur.
